# EUROPÄISCHE PATENTSCHRIFT

(11) **EP 0 940 009 B1**
(45) Veröffentlichungstag und Bekanntmachung des Hinweises auf die Patenterteilung: **18.02.2004**
(21) Anmeldenummer: 98951189.4
(22) Anmeldetag: 21.08.1998
(51) Int. Cl.: H03H 17/04, H03H 17/02

(54) **KAMMFILTER**
COMB FILTER
FILTRE EN PEIGNE

(30) Priorität: 23.09.1997 DE 19741922
(43) Veröffentlichungstag der Anmeldung: 08.09.1999
(73) Patentinhaber: Infineon Technologies AG, 81669 München (DE)
(72) Erfinder: DRAXELMAYR, Dieter, A-9500 Villach (AT)
(74) Vertreter: Zimmermann & Partner
(86) Internationale Anmeldenummer: PCT/DE1998/002453
(87) Internationale Veröffentlichungsnummer: WO 1999/016169

(56) Entgegenhaltungen:
- EP-A- 0 762 647

## Beschreibung

Die Erfindung betrifft ein Kammfilter aus in Reihe geschalteten Integratoren, denen ein digitaler Datenstrom hoher Abtastrate zugeführt ist, um einen digitalen Datenstrom niedriger Abtastrate zu liefern.

Sogenannte Dezimierungsfilter werden verwendet, um einen digitalen Datenstrom mit hoher Abtastrate in einen Datenstrom mit niedriger Abtastrate zu überführen. Die Filterfunktion solcher Dezimierungsfilter hat üblicher Weise Tiefpaßeigenschaften und bewirkt eine Wortbreitenerhöhung der durch das Dezimierungsfilter dezimierten Daten. Es kann damit ein 1-Bit Strom hoher Abtastrate in beispielsweise 16-Bit Worte im Sprachband dezimiert werden.

Ein Anwendungsgebiet ist die digitale Telefontechnik. Dabei wird einem Sigma-Delta-Analog/Digital-Umsetzer mindestens ein solches Dezimierungsfilter nachgeschaltet.

Üblicherweise wird der Dezimierungsfaktor eines Dezimierungsfilters durch eine Zweierpotenz, also 2, 4, 16, 64 usw. bestimmt. Die übliche Struktur für ein solches Dezimierungsfilter wird durch ein Kammfilter geliefert, da sich ein solches mit relativ geringem Aufwand realisieren läßt.

Fig. 2 zeigt ein Beispiel eines auch aus EP 0 762 647 bekannten Kamm- bzw. Dezimierungsfilters, bei dem drei sogenannte Dump-Integratoren I (I1, I2, I3) mit jeweils einem Summierglied S und einem Verzögerungsglied V im Rückkopplungszweig in einer Kette geschaltet sind und jeweils nach N Takten über das zugehörige Verzögerungsglied V rückgesetzt werden, was durch "reset N" angedeutet ist. Die Wortbreite m₁ bzw. m₂ bzw. m₃ des Ausgangs-Datenstromes der Summierglieder S kann an die Dump-Integratoren I angepaßt sein.

Der Kettenschaltung aus Integratoren I ist eine transversale Superpositionsstufe TS aus weiteren Summiergliedern, Verzögerungsgliedern V mit N-facher Verzögerung und Multiplizierern M nachgeschaltet, wobei N den Summierungsfaktor bezeichnet.

Es ist **Aufgabe** der vorliegenden Erfindung, ein als Dezimierungsfilter geeignetes Kammfilter zu schaffen, das sich durch eine einfache Struktur auszeichnet.

Diese Aufgabe wird bei einem Kammfilter der eingangs genannten Art erfindungsgemäß dadurch gelöst, daß die höchstwertigen Bits des digitalen Datenstromes in den Integratoren rücksetzbar sind, daß das Rücksetzen der Bits im ersten Integrator in einem Zähler speicherbar ist und daß der Zählerstand des Zählers zur Rücksetzzeit in mindestens ein Bit, bevorzugt die höchstwertigen Bits des letzten Integrators einspeisbar ist.

Die Erfindung hat den Vorteil, daß sich ein Rücksetzfehler in später folgenden Stufen als Vielfaches einer Zweierpotenz darstellt, so daß er in den folgenden Stufen besonders einfach korrigierbar ist.

Die Anzahl der Integratoren ist dabei grundsätzlich nicht begrenzt, wenngleich in vielen Anwendungsfällen drei Integratoren ausreichend sind. Entsprechend wird nachfolgend auf Ausführungsbeispiele mit drei Integratoren, d. h. Filter 3. Ordnung, bezug genommen.

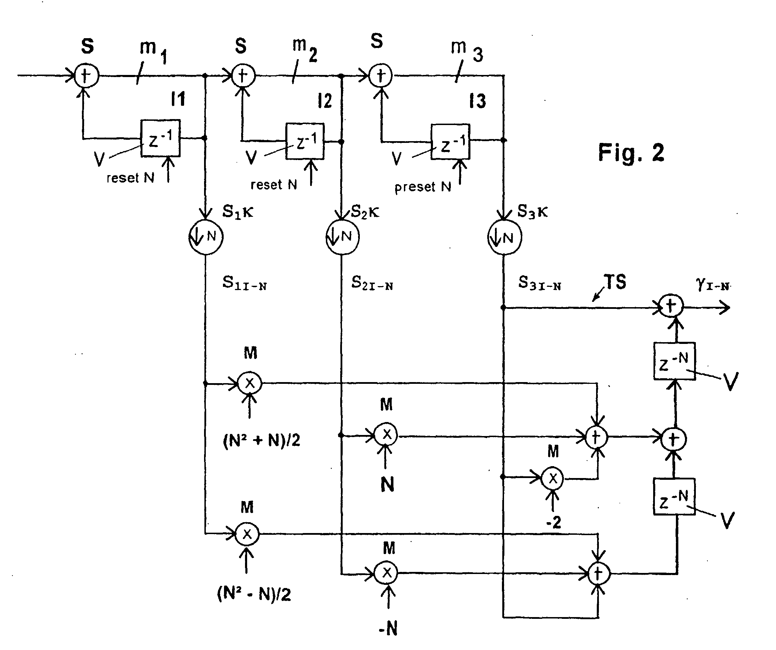

Bei dem erfindungsgemäßen Kammfilter wird also anders als in dem bekannten Kammfilter von Fig. 2 das Rücksetzsignal nicht auf die gesamten Integratoren geführt, sondern nur auf die höchstwertigen Bits angewandt. Das führt dazu, daß als Rechenwerk zur Korrektur der Rücksetzfehler lediglich ein einfacher Zähler benötigt wird. Insbesondere wird der letzte Integrator - bei einer dreistufigen Anordnung also der dritte Integrator - nicht auf Null, sondern auf einen von dem Zähler bestimmten Wert vorgesetzt.

Die Ursachen hierfür sollen im folgenden näher erläutert werden:

Ein Kammfilter dritter Ordnung mit einem Dezimierungsfaktor von 256 (2∧8) hat einen Zahlenbereich von Null bis 256∧3. Wird nun darauf verzichtet 256∧3 darzustellen und dafür der Wert Null akzeptiert, so sind für eine Darstellung 24 Bits erforderlich. Bei Darstellung von 256∧3 würden 25 Bits benötigt werden, was bedeutet, daß sich die folgenden Überlegungen um 1 Bit verschieben.

Rechenfehler modulo 256∧3 fallen demnach nicht auf und können ignoriert werden. Es reichen also 24 Bits Rechengenauigkeit, um ein exaktes Ergebnis zu erzielen.

Wenn zu einer bestimmten Zeit ein Fehler f1 in den ersten Integrator kommt, was beispielsweise durch ein Rücksetzen geschehen kann, so wird dieser Fehler nach 256 Takten am Ausgang des dritten Integrators bewertet. Dort beträgt der Fehler dann f3=f1*256*257/2=f1*128*(256+1). Beträgt nun der Fehler f1 beispielsweise a*512, so ergibt sich f3=a*512*128*256+a*512*128. Modulo 256∧3 betrachtet also a*256∧2.

Dies bedeutet folgendes:

wenn der dritte Integrator nicht auf den Wert Null, sondern auf den Wert -a*256*256 gesetzt wird, so wird der Fehler f1 kompensiert. Entsprechendes gilt nicht nur für 256 Takte sondern auch für beliebige Vielfache hiervon. Die Ursache liegt darin, daß der dritte Integrator gleichzeitig auch als Differenzierer arbeitet und daß bei einer Differentiation der sich ansammelnden Werte immer -a*256*256 als Ergebnis vorliegt.

Der Wert von a ergibt sich dabei folgendermaßen: Im ersten Integrator wird zur Rücksetzzeit das Bit mit der Wertigkeit 512 rückgesetzt. Wenn es vorher den Wert 1 hatte, so entsteht also genau der oben angeführte Fehler f1. Dieser Fehler addiert sich zu den vorhergehenden, entsprechend aufgetretenen Fehlern. Deshalb wird hier einfach der Fehlerzähler des ersten Integrators inkrementiert. Dieser Fehlerzähler lädt seinerseits den letzten bzw. dritten Integrator. Das negative Vorzeichen verschwindet deshalb, weil a üblicherweise negativ ist, da der Fehler beim Rücksetzen eines Bits entsteht.

Um darüber hinaus keine weiteren Fehler auftreten zu lassen, muß der erste Integrator immer 10 Bit breit sein. Der Fehlerzähler, der dem ersten Integrator nachgeschaltet ist, beinhaltet Vielfache von 256∧2 und muß demnach 8 Bit breit sein, da insgesamt 24 Bit Rechengenauigkeit vorausgesetzt sind. Das heißt, es genügt ein "kleiner" Zähler.

Vom ersten Integrator kommen also Werte bis maximal 767. In 256 Takten kann sich dieser Wert auf höchstens Werte kleiner/gleich 767*256=196352 akkumulieren. Der Startwert des zweiten Integrators liegt bei Werten kleiner 2∧16, so daß eine Wortbreite von 18 Bit ausreichend ist, um einen unkontrollierten Überlauf zu vermeiden. Zur Rücksetzzeit können alle Bits, die 2∧16 und Vielfache hiervon symbolisieren, gelöscht werden, weil der Summenfehler nach 256 Takten im dritten Integrator den Wert 2∧24 oder ein Vielfaches davon hat und daher nicht berücksichtigt zu werden braucht. Das heißt, der Startwert nach Rücksetzen liegt bei dem zweiten Integrator, also bei Werten, die kleiner als 2∧16 sind, wie dies bereits oben angenommen wurde.

Insgesamt arbeitet das erfindungsgemäße Kammfilter also in der folgenden Weise:

Ein synchrones Rücksetzen der höchstwertigen Bits wird im ersten Integrator um 1 Bit und im zweiten Integrator um 2 Bits vorgenommen. Dabei wird das Rücksetzen der Bits im ersten Integrator in einem dem ersten Integrator nachgeschalteten Fehlerzähler gespeichert, der eine Wortbreite von 8 Bits hat. Der so ermittelte Zählerstand wird dann zur Rücksetzzeit in die höchstwertigen Bits des letzten bzw. dritten Integrators eingespeist, der gleichzeitig als Differenzierer wirkt. Die niederwertigeren Bits des letzten bzw. dritten Integrators werden in der gewohnten Weise rückgesetzt, wobei weitere Rechenschritte nicht erforderlich sind.

Die Erfindung schafft so ein einfach aufgebautes Kammfilter, das sich mit geringem Aufwand realisieren läßt und einen digitalen Datenstrom mit hoher Abtastrate zuverlässig in einen digitalen Datenstrom mit geringerer Abtastrate überführen kann.

Nachfolgend wird die Erfindung anhand der Zeichnungen eines in der Zeichnung dargestellten Ausführungsbeispieles weiter erläutert. Es zeigen:
- Fig. 1: ein Blockschaltbild eines erfindungsgemäßen Kammfilters, und
- Fig. 2: ein Blockschaltbild eines herkömmlichen Kammfilters.

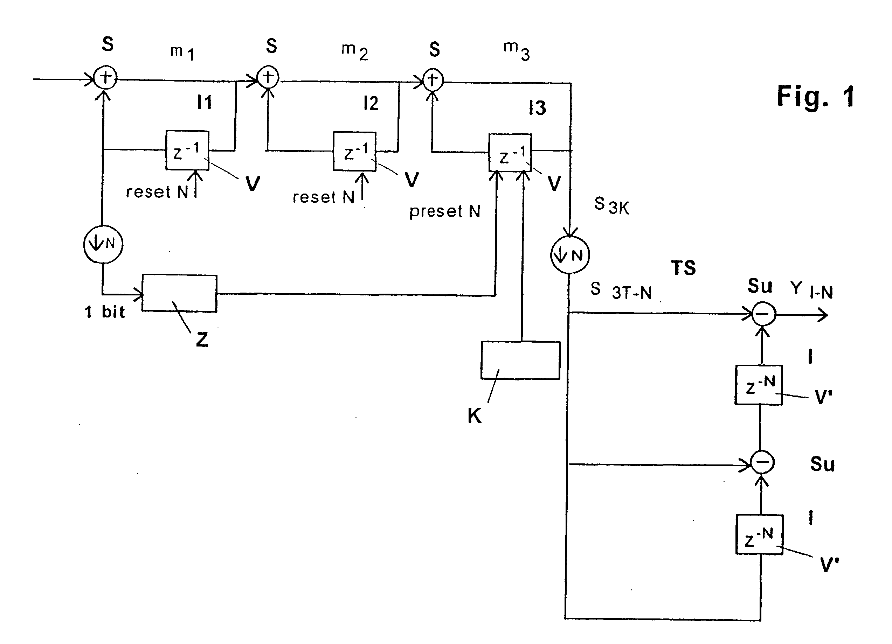

Fig. 2 ist bereits vorstehend erläutert worden. In Fig. 1 werden für entsprechende Teile die gleichen Bezugszeichen wie in Fig. 2 verwendet.

In Fig. 1 sind drei Integratoren, I1, I2, I3, mit Summierern S wie in Fig. 2 in einer Kette angeordnet, wobei die Wortbreite m₁, m₂ bzw. m₃ an diese Integratoren I1, 12 und I3 angepaßt sein kann. Im Unterschied zu dem bestehenden Kammfilter gemäß Fig. 2 ist bei dem erfindungsgemäßen Kammfilter dem Integrator I1 ein Zähler Z mit einer Wortbreite von 8 Bits nachgeschaltet, der das Rücksetzen der Bits im Integrator I1 zählt. Der so im Zähler Z ermittelte Zählerstand wird dann zur Rücksetzzeit in die höchstwertigen Bits des dritten Integrators I3, der gleichzeitig als Differenzierer wirkt, eingespeist, während die niederwertigeren Bits des dritten Integrators I3 in üblicher Weise rückgesetzt werden. Das gesamte Verzögerungsglied wird zurückgesetzt, ein selektives Zurücksetzen ist nicht vorgesehen.

Bei Kettenschaltung aus den Integratoren I1, I2 und I3 ist wiederum eine transversale Superpositionsstufe PS aus Subtrahierern Su und Integratoren I nachgeschaltet.

Über ein Register K kann wahlweise ein beliebig wählbarer, im Register K gespeicherter Korrekturwert in den dritten Integrator I3 eingegeben werden.

Als einfachste Ausführung eines Integrators I kann hierfür ein Zähler verwendet werden. Das ergibt sich daraus, daß beispielsweise im ersten Integrator zu jedem Zeitschritt maximal ein Bit addiert werden kann, was einem Zählerschritt von 1 entspricht. Dies gilt auch für höherwertige Bits in den nachfolgenden Integratoren, da dort nur die Überläufe der niederwertigen Bits zugeführt werden.

## Patentansprüche

1. Kammfilter aus mindestens drei in Reihe geschalteten Integratoren (I1, I2, I3), denen ein digitaler Datenstrom hoher Abtastrate zugeführt ist, um einen digitalen Datenstrom niedriger Abtastrate zu liefern,
daß die höchstwertigen Bits des digitalen Datenstroms in den Integratoren (I1, I2) rücksetzbar sind, **dadurch gekennzeichnet, daß** das Rücksetzen der Bits im ersten Integrator (I1) in einem Zähler (Z) speicherbar ist, und daß der Zählerstand des Zählers (Z) zur Rücksetzzeit selektiv in mindestens ein Bit des letzten Integrators (I3) einspeisbar ist.

2. Kammfilter nach Anspruch 1,
**dadurch gekennzeichnet,**
**daß** der Zählerstand des Zählers (Z) zur Rücksetzzeit in die höchstwertigen Bits des letzten Integrators (I3) einspeisbar ist.

3. Kammfilter nach Anspruch 1,
**dadurch gekennzeichnet,**
**daß** der letzte Integrator (I3) gleichzeitig als Differenzierer wirkt.

4. Kammfilter nach einem der vorhergehenden Ansprüche
**dadurch gekennzeichnet,**
**daß** ein Korrekturwert in die höchstwertigen Bits des letzten Integrators (I3) einspeisbar ist.

5. Kammfilter nach Anspruch 4,
**dadurch gekennzeichnet,**
**daß** der Korrekturwert über den Zähler (7) einspeisbar ist.

6. Kammfilter nach einem der vorhergehenden Ansprüche,
**dadurch gekennzeichnet,**
**daß** die Integratoren (91, 92, 93) als Zähler ausgebildet sind.

## Claims

1. Comb filter comprising at least three series-connected integrators (I1, I2, I3), to which is fed a digital data stream at a high sampling rate in order to yield a digital data stream at a low sampling rate,
**characterized**
**in that** the most significant bits of the digital data stream can be reset in the integrators (I1, I2), in that it is possible to store the resetting of the bits in the first integrator (I1) in a counter (Z), and in that the counter reading of the counter (Z) can be fed selectively into at least one bit of the last integrator (I3) at the reset time.

2. Comb filter as claimed in Claim 1,
**characterized**
**in that** the counter reading of the counter (Z) can be fed into the most significant bits of the last integrator (I3) at the reset time.

3. Comb filter as claimed in Claim 1,
**characterized**
**in that** the last integrator (I3) simultaneously acts as a differentiator.

4. Comb filter as claimed in one of the preceding Claims,
**characterized**
**in that** a correction value can be fed into the most significant bits of the last integrator (I3).

5. Comb filter as Claimed in Claim 4,
**characterized**
**in that** the correction value can be fed in via the counter (7).

6. Comb filter as Claimed in one of the preceding Claims,
**characterized**
**in that** the integrators (91, 92, 93) are designed as counters.

## Revendications

1. Filtre en peigne constitué d'au moins trois intégrateurs (I1, I2, I3) montés en série, auxquels est envoyé un flux de données numériques de grand débit d'échantillonnage pour fournir un flux de données numériques de débit d'échantillonnage plus petit, les bits les plus significatifs du flux de données numériques pouvant être remis à l'état initial dans les intégrateurs (I1, I2), **caractérisé en ce que** la remise à l'état initial des bits dans le premier intégrateur (I1) peut être mémorisée dans un compteur (Z) et **en ce que** l'état du compteur (Z) peut être injecté à l'instant de la remise à l'état initial sélectivement dans au moins un bit du dernier intégrateur (13).

2. Filtre en peigne suivant la revendication 1, **caractérisé en ce que** l'état du compteur (Z) peut être injecté à l'instant de la remise à l'état initial dans les bits les plus significatifs du dernier intégrateur (13).

3. Filtre en peigne suivant la revendication 1, **caractérisé en ce que** le dernier intégrateur (I3) agit en même temps en tant que différentiateur.

4. Filtre en peigne suivant l'une des revendications précédentes, **caractérisé en ce qu'**une valeur de correction peut être injectée dans les bits les plus significatifs du dernier intégrateur (I3).

5. Filtre en peigne suivant la revendication 4, **caractérisé en ce que** la valeur de correction peut être injectée par le compteur (7).

6. Filtre en peigne suivant l'une des revendications précédentes, **caractérisé en ce que** les intégrateurs (91, 92, 93) sont constitués en compteurs.
